# EUROPÄISCHE PATENTANMELDUNG

(11) **EP 2 894 678 A1**
(43) Veröffentlichungstag der Anmeldung: **15.07.2015**
(21) Anmeldenummer: 14190109.0
(22) Anmeldetag: 27.01.2004
(51) Int. Cl.: H01L 33/00, H01L 21/78, H01L 21/268

(54) **Verfahren zur Herstellung eines Halbleiterbauelements**

(30) Priorität: 31.01.2003 DE 10303977
(62) Teilanmeldung aus: 04705373.1
(71) Anmelder: Osram Opto Semiconductors Gmbh, 93055 Regensburg (DE)
(72) Erfinder: Kaiser, Stephan, 93049 Regensburg (DE); Härle, Volker, 93180 Deuerling (DE); Hahn, Berthold, 93155 Hemau (DE)
(74) Vertreter: Epping - Hermann - Fischer

(57) **Zusammenfassung**

Es wird ein Verfahren zur Herstellung eines Halbleiterbauelements angegeben, bei dem eine Halbleiterschicht (2) von einem Substrat (1) durch Bestrahlen mit Laserimpulsen (6) getrennt wird, wobei die Impulsdauer der Laserimpulse (6) kleiner oder gleich 10 ns ist. Bei dem Verfahren wird vor der Trennung von dem Substrat (1) die Halbleiterschicht (2) mit der von dem Substrat (1) abgewandten Seite auf einen Träger (4) aufgebracht und die Laserimpulse (6) weisen ein räumliches Strahlprofil (7) auf, dessen Flankensteilheit so gering gewählt ist, daß Risse in der Halbleiterschicht (2), die durch thermisch induzierte laterale Verspannungen entstehen, vermieden werden, wobei das räumliche Strahlprofil gaußartige, hypergaußartige oder lorentzartige Flanken aufweist. Das Substrat weist weiterhin Saphir auf und der Träger (4) ist ein Molybdän-Wafer.

## Beschreibung

Die Erfindung bezieht sich auf ein Verfahren zur Herstellung eines Halbleiterbauelements, bei dem eine Halbleiterschicht von einem Substrat durch Bestrahlen mit einem Laserstrahl getrennt wird.

Ein derartiges Verfahren kommt beispielsweise bei der Herstellung substratloser Lichtemissionsdioden (Lumineszenzdioden) auf der Basis von GaN zum Einsatz. Solche Bauelemente enthalten einen Halbleiterkörper und ein Trägerteil, auf dem der Halbleiterkörper befestigt ist. Zur Herstellung des Halbleiterkörpers wird zunächst eine Halbleiterschicht auf einem geeigneten Substrat gefertigt, nachfolgend mit einem Träger verbunden und dann von dem Substrat abgelöst. Durch Zerteilen, beispielsweise Zersägen, des Trägers mit der darauf angeordneten Halbleiterschicht entsteht eine Mehrzahl von Halbleiterkörpern, die jeweils auf dem entsprechenden Trägerteil befestigt sind. Wesentlich ist hierbei, daß das zur Herstellung der Halbleiterschicht verwendete Substrat von der Halbleiterschicht entfernt wird und nicht zugleich als Träger bzw. Trägerteil im Bauelement dient.

Dieses Herstellungsverfahren hat den Vorteil, daß verschiedene Materialien für das Substrat und den Träger verwendet werden. Damit können die jeweiligen Materialien an die unterschiedlichen Anforderungen für die Herstellung der Halbleiterschicht einerseits und die Betriebsbedingungen andererseits weitgehend unabhängig voneinander angepaßt werden. So kann der Träger entsprechend seiner mechanischen, thermischen und optischen Eigenschaften unabhängig von den Anforderungen an das Substrat zum Fertigen der Halbleiterschicht gewählt werden.

Insbesondere die epitaktische Herstellung einer Halbleiterschicht stellt zahlreiche spezielle Anforderungen an das Epitaxiesubstrat. Beispielsweise müssen die Gitterkonstanten des Substrats und der aufzubringenden Halbleiterschicht aneinander angepaßt sein. Weiterhin sollte das Substrat den Epitaxiebedingungen, insbesondere Temperaturen bis über 1000°C, standhalten und für das epitaktische An- und Aufwachsen einer möglichst homogenen Schicht des betreffenden Halbleitermaterials geeignet sein.

Für die weitere Verarbeitung des Halbleiterkörpers und den Betrieb hingegen stehen andere Eigenschaften des Trägers wie beispielsweise elektrische und thermische Leitfähigkeit sowie Strahlungsdurchlässigkeit bei optoelektronischen Bauelementen im Vordergrund. Die für ein Epitaxiesubstrat geeigneten Materialien sind daher als Trägerteil im Bauelement oftmals nur bedingt geeignet. Schließlich ist es insbesondere bei vergleichsweise teuren Epitaxiesubstraten wie beispielsweise Siliziumkarbidsubstraten wünschenswert, die Substrate mehrmals verwenden zu können.

Für das genannte Herstellungsverfahren ist die Ablösung der Halbleiterschicht von dem Substrat wesentlich. Diese Ablösung kann durch Bestrahlung der Halbleiter-Substrat-Grenzfläche mit Laserstrahlung erreicht werden. Dabei wird die Laserstrahlung in der Nähe der Grenzfläche absorbiert und bewirkt dort eine Zersetzung des Halbleitermaterials.

Die Trennung der Halbleiterschicht von dem Substrat kann beispielsweise durch Laserablösen, wie in der Druckschrift WO 98/14986 beschrieben, erfolgen. Dabei wird für die Ablösung von GaN- und GaInN-Schichten von einem Saphirsubstrat die frequenzverdreifachte Strahlung eines Q-switch Nd:YAG-Lasers mit einer Impulsdauer zwischen 1 ns und 10 ns und einer Wellenlänge von 355 nm verwendet. Das Saphirsubstrat ist für Strahlung dieser Wellenlänge transparent. Die Strahlungsenergie wird in einer etwa 50 nm bis 300 nm dicken Grenzschicht am Übergang zwischen dem Saphirsubstrat und der GaN-Halbleiterschicht absorbiert. Bei Impulsenergien oberhalb von 200 mJ/cm² werden an der Grenzfläche Temperaturen von mehr als 850 °C erreicht. Die GaN-Grenzschicht zersetzt sich bei dieser Temperatur unter Freisetzung von Stickstoff, die Bindung zwischen der Halbleiterschicht und dem Substrat wird getrennt.

In der Regel ist eine mechanische Stabilisierung der abzulösenden Halbleiterschicht erforderlich, da die Schichtdicke so gering ist, daß ansonsten die Gefahr einer Beschädigung, insbesondere eines Bruchs oder Risses der Schicht, besteht. Dazu kann die Halbleiterschicht mit einem geeigneten Träger verbunden werden. Eine derartige Verbindung sollte zumindest so weit temperaturstabil sein, daß sie die bei nachfolgenden Fertigungsschritten auftretenden Temperaturen unbeschadet übersteht. Weiterhin sollte diese Verbindung auch bei Temperaturwechselbelastungen, die insbesondere im Betrieb des Bauelements auftreten können, stabil bleiben.

Es hat sich gezeigt, daß hierbei die einzelnen Laserparameter von entscheidender Bedeutung für das Ergebnis des Ablöseprozesses sind. Insbesondere müssen die Laserparameter so aufeinander abgestimmt sein, daß einerseits die Halbleiterschicht möglichst vollständig und rückstandsfrei abgelöst wird, andererseits aber die Verbindung mit dem genannten Träger nicht beeinträchtigt wird.

Es ist Aufgabe der vorliegenden Erfindung, ein verbessertes Herstellungsverfahren für ein Halbleiterbauelement, bei dem eine Halbleiterschicht mittels Laserbestrahlung von einem Substrat getrennt wird, zu entwickeln.

Diese Aufgabe wird durch ein Verfahren nach Patentanspruch 1 gelöst. Vorteilhafte Weiterbildungen der Erfindung sind Gegenstand der abhängigen Ansprüche.

Die Erfindung beruht auf der Feststellung, daß für eine möglichst vollständige und rückstandsfreie Ablösung der Halbleiterschicht von dem Substrat bei gegebener Energie für die Zersetzung des Halbleitermaterials insbesondere die Impulsdauer und das Strahlprofil aufeinander abzustimmen sind. Die Impulsdauer ist so zu wählen, daß kurzzeitig die für die thermische Zersetzung der Halbleiterschicht an der Grenzfläche zum Substrat erforderliche Temperatur erreicht wird. Dabei ist aber zu berücksichtigen, daß der gesamte Energieeintrag in die Halbleiterschicht und die damit verbundene Temperaturerhöhung der Halbleiterschicht insgesamt so gering zu halten ist, daß die Verbindung mit dem Träger nicht beeinträchtigt wird. Insbesondere ist ein Aufschmelzen einer Lötverbindung zwischen Träger und Halbleiterschicht zu vermeiden, da ansonsten die Gefahr besteht, daß sich beim Ablöseprozeß der Träger und nicht wie gewünscht das Substrat von der Halbleiterschicht löst.

Es hat sich im Rahmen der Erfindung gezeigt, daß eine Impulsdauer kleiner oder gleich 10 ns vorteilhaft ist. Insbesondere zeigten Experimente, daß bei Impulsdauern über 10 ns, z.B. bei 15 ns, eine Lötverbindung zwischen Träger und Halbleiterschicht bereits teilweise aufschmelzen kann.

Weiter wurde im Rahmen der Erfindung festgestellt, daß bei einer Trennung mit Laserimpulsen, die eine Impulsdauer kleiner oder gleich 10 ns aufweisen, ein räumlich gaußförmiges Strahlprofil vorteilhaft ist. Bei der Bestrahlung mit Laserimpulsen entsteht jeweils zwischen dem bestrahlten Bereich innerhalb des Laserimpulses und der nicht bestrahlten Umgebung eine Temperaturdifferenz in der Halbleiterschicht, die aufgrund der entsprechend unterschiedlichen thermischen Ausdehnung in lateraler Richtung zu mechanischen Verspannungen führt. Mit steigender Flankensteilheit des räumlichen Strahlprofils wächst auch der thermische Gradient und damit letztendlich die Gefahr, daß die mechanischen Spannungen Risse in der Halbleiterschicht hervorrufen. Ein gaußförmiges räumliches Strahlprofil hat sich hierbei als vorteilhaft erwiesen, wobei die Flankensteilheit so zu wählen ist, daß Risse in der Halbleiterschicht vermieden werden. Auch ein Lorentzprofil, ein Hypergaußprofil mit jeweils entsprechender Flankensteilheit oder weitergehend ein Profil mit gauß-, lorentz- oder hypergaußartigen Flanken könnte als Strahlprofil verwendet werden.

Erfindungsgemäß ist vorgesehen, eine Halbleiterschicht von einem Substrat durch Bestrahlen mit Laserimpulsen, deren Impulsdauer kleiner oder gleich 10 ns ist, zu trennen, wobei die Laserimpulse ein räumliches Strahlprofil, bevorzugt ein gaußartiges Strahlprofil, aufweisen, dessen Flankensteilheit so gering gewählt ist, daß bei der Trennung von Halbleiterschicht und Substrat Risse in der Halbleiterschicht, die durch thermisch induzierte laterale Verspannungen entstehen, vermieden werden.

Bevorzugt werden bei der Erfindung die Laserimpulse von einem Festkörperlaser mit einem Nd-dotierten laseraktiven Medium, insbesondere Nd:YAG oder auch Nd:YLF oder Nd:KGW erzeugt. Die Hauptemissionswellenlänge beträgt etwa 1060nm (z.B. 1064 nm für Nd:YAG), so daß eine für die Ablösung vorteilhafte Wellenlänge im ultravioletten Spektralbereich durch Frequenzverdreifachung mittels eines nichtlinearen optischen Elements erreicht werden kann. Bevorzugt liegt die Wellenlänge der zur Trennung verwendeten Laserimpulse zwischen 200 nm und 400 nm, besonders bevorzugt zwischen 300 nm und 400 nm.

Alternativ können die Laserimpulse auch mittels eines Excimer-Lasers erzeugt werden. Insbesondere Excimer-Lasern mit einer Edelgas-Halogen-Verbindung als Lasermedium zeichnen sich durch eine vorteilhafte Emissionswellenlänge im ultravioletten Spektralbereich und eine hohe Impulsspitzenleistung, die typischerweise zwischen 1kW und 100 MW liegt, aus.

Da Excimer-Laser in der Regel eher ein rechteckartiges Strahlprofil mit steilen Flanken aufweisen, ist ein entsprechender Strahlformer vorzusehen, der das Strahlprofil in ein räumliches Strahlprofil mit ausreichend flachen Flanken, bevorzugt ein gaußförmiges Strahlprofil, umwandelt.

Bei Halbleiterschichten mit größerer lateraler Ausdehnung ist es vorteilhaft, nebeneinander angeordnete Einzelbereiche der Halbleiterschicht nacheinander zu bestrahlen, um eine zu große Aufweitung der Strahlfläche zu vermeiden. Hierbei ist es zweckmäßig, den Laserstrahl und/oder das Substrat mit der darauf befindlichen Halbleiterschicht so zu führen, daß die bestrahlten Einzelbereiche eine flächenfüllende Gesamtanordnung ergeben.

Bevorzugt wird bei der Erfindung der unmittelbare Grenzflächenbereich zwischen Halbleiterschicht und Substrat mit den Laserimpulsen bestrahlt, so daß die Strahlungsenergie grenzflächennah absorbiert wird und dort zu einer Materialzersetzung führt. Dies kann dadurch erreicht werden, daß das Substrat für die Laserstrahlung durchlässig ist und die Halbleiterschicht durch das Substrat hindurch bestrahlt wird. Bei dieser Anordnung ist in der Regel die Absorption der Laserstrahlung in der Halbleiterschicht wesentlich größer als in dem Substrat, so daß der Laserstrahl das Substrat nahezu verlustfrei durchdringt und aufgrund der hohen Absorption grenzflächennah in der Halbleiterschicht absorbiert wird.

Es sei angemerkt, daß die Strahlungsabsorption nicht notwendigerweise am Ort der Materialzersetzung erfolgen muß. Die Materialzersetzung kann auch dadurch bewirkt werden, daß die Strahlung zunächst an einem anderen Ort absorbiert wird und nachfolgend ein Energietransport der absorbierten Strahlungsenergie an die Stelle der Materialzersetzung stattfindet. Gegebenenfalls könnte die Strahlung auch in dem Substrat absorbiert und nachfolgend die Strahlungsenergie zur Halbleiterschicht transportiert werden.

Eine bevorzugte Weiterbildung der Erfindung besteht darin, die Halbleiterschicht vor der Trennung von dem Substrat derart zu strukturieren, daß die Halbleiterschicht in eine Mehrzahl einzelner Halbleiterkörper zerteilt wird. Beispielsweise können dazu grabenförmige Vertiefungen in der Halbleiterschicht geformt werden, die die zu bildenden Halbleiterkörper lateral umschließen und in der Tiefe bevorzugt bis zum Substrat reichen. Derartige Vertiefungen können beispielsweise mittels eines geeigneten Ätzverfahrens hergestellt werden. Durch diese sogenannte "Chipstrukturierung" wird vorteilhafterweise die Halbleiterschicht in lateraler Richtung zumindest teilweise unterbrochen. Damit können mechanische Verspannungen in der Halbleiterschicht reduziert werden.

Vorzugsweise werden die Halbleiterschicht bzw. die Halbleiterkörper nachfolgend mit einer Passivierungsschicht versehen. Diese Passivierungsschicht schützt die durch die Strukturierung freigelegten Seitenflächen der Halbleiterkörper. Vorteilhaft ist hierbei eine elektrisch nichtleitende Passivierungsschicht, um einen Kurzschluß der Halbleiterschicht durch elektrisch leitfähiges Material, das bei nachfolgenden Verarbeitungsschritten auf die freigelegten Seitenflächen der Halbleiterkörper gelangen kann, zu vermeiden.

Bei einem weiteren Aspekt der Erfindung ist vorgesehen, daß vor der Trennung die Halbleiterschicht mit der von dem Substrat abgewandten Seite auf einen Träger aufgebracht, vorzugsweise aufgelötet, wird. Eine Lötverbindung zeichnet sich gegenüber herkömmlichen Klebstoffverbindungen durch eine hohe thermische und elektrische Leitfähigkeit aus.

Als Lot wird vorzugsweise ein goldhaltiges Lot, beispielsweise ein Gold-Zinn-Lot, verwendet. Besonders bevorzugt sind hierbei Gold-Zinn-Lote mit einem hohen Goldanteil, beispielsweise zwischen 65 Gew% und 85 Gew%.

Die Schmelztemperatur eines solchen Lots beträgt typischerweise 278°C und ist somit größer als die Temperatur, die üblicherweise beim Verlöten eines elektrischen Bauelements entsteht. So ist beispielsweise die Löttemperatur beim Auflöten auf eine Leiterplatte in der Regel kleiner als 260°C. Damit wird verhindert, daß sich beim Verlöten des Bauelements der Halbleiterkörper von dem Trägerteil ablöst.

Weiterhin eignet sich als Lot beispielsweise ein Palladium-Indium-Lot, dessen Bestandteile sich bei einer vergleichsweise niedrigen Anfangstemperatur von etwa 200°C durchmischen, und das nach der Durchmischung eine vorteilhaft hohe Schmelztemperatur von über 660°C aufweist.

Eine derartige Verbindung kann beispielsweise dadurch hergestellt werden, daß auf der Halbleiterschicht eine Gold-Schicht und auf dem Träger eine Gold-Zinn-Schicht aufgebracht wird und nachfolgend der Träger und die Halbleiterschicht zusammengefügt werden. Dabei können zwischen der Halbleiterschicht und der Metallschicht weitere Schichten vorgesehen sein, die beispielsweise einen Schutz der Halbleiterschicht oder eine gute Haftung gewährleisten.

Hinsichtlich eines geringen Kontaktwiderstands und vorteilhafter Löteigenschatten ist es zweckmäßig, die Halbleiterschicht auf der dem Träger zugewandten Seite vor dem Auflöten auf den Träger mit einer Kontaktmetallisierung zu versehen. Hierfür eignet sich beispielsweise eine Platin-Gold-Metallisierung.

Bei einem weiteren Aspekt der Erfindung ist vorgesehen, daß der thermische Ausdehnungskoeffizient des Trägers abgestimmt auf den thermischen Ausdehnungskoeffizienten der Halbleiterschicht und/oder den thermischen Ausdehnungskoeffizienten des Substrats sowie die Impulsdauer der Laserimpulse gewählt ist.

Allgemein ist unter einer Abstimmung der thermischen Ausdehnungskoeffizienten zu verstehen, daß deren Differenz so klein ist, daß in dem bei der Herstellung auftretenden bzw. im Betrieb vorgesehenen Temperaturbereich keine Schäden an der Halbleiterschicht und dem Träger entstehen. Insbesondere können dadurch Verspannungen zwischen Substrat, Halbleiterschicht und Träger während der Herstellung deutlich reduziert werden. Die Gefahr von Rißbildungen im Träger und in der Halbleiterschicht wird damit stark herabgesetzt.

Zwar fallen die an der Halbleiteroberfläche erreichten Temperaturen über die Schichtdicke der Halbleiterschicht deutlich ab, doch werden an der Trägerseite der Halbleiterschicht im Bereich des Laserimpulses noch Temperaturen von etwa 200°C bis 400°C erreicht. Somit entstehen aufgrund der lokal unterschiedlichen Temperaturen innerhalb und außerhalb des bestrahlten Bereichs sowohl in der Halbleiterschicht als auch im Träger aufgrund der im allgemeinen unterschiedlichen thermischen Ausdehnungskoeffizienten des Halbleitermaterials und des Trägermaterials Zugverspannungen, die zu der beobachteten Ausbildung von Rissen im Halbleitermaterial an den Rändern des jeweils bestrahlten Bereichs führen können.

Bei der weiteren Prozessierung von derartigen mit Rissen versehenen Halbleiterschichten entsteht beispielsweise das Problem, daß Säure entlang der Risse unter die Halbleiterschicht kriechen kann und dort etwa eine Bondmetallisierung zerstört.

Bei der Erfindung werden bevorzugt Trägermaterialien verwendet, deren thermische Eigenschaften speziell an den Ablöseprozeß adaptiert sind. Hierbei ist es von Vorteil, das Trägermaterial so wählen, daß der thermische Ausdehnungskoeffizient des Trägers näher an dem thermischen Ausdehnungskoeffizienten der Halbleiterschicht als an dem thermischen Ausdehnungskoeffizienten des Substrats liegt. Mit einer derartigen Wahl kann die Ausbildung von Rissen in der Halbleiterschicht wirkungsvoll reduziert oder ganz vermieden werden.

Es sei angemerkt, daß bei der Erfindung die Anpassung der thermischen Eigenschaften von Substrat, Träger und Halbleiterschicht vorteilhaft für eine möglichst vollständige und rückstandsfreie Ablösung ist. Die Erfindung weist aber auch den Vorteil auf, daß aufgrund der kurzen Impulsdauer kleiner oder gleich 10 ns die Anforderungen an diese Anpassung der thermischen Eigenschaften geringer sind als bei herkömmlichen Verfahren mit längerer Impulsdauer. Somit kann die Erfindung einerseits dazu dienen, eine möglichst gute Ablösung zu erreichen. Andererseits können im Rahmen der Erfindung mit Vorteil auch Trägermaterialien verwendet werden, die hinsichtlich ihrer thermischen Eigenschaften geeignet, wenn auch nicht optimal sind, aber andere wünschenswerte Eigenschaften wie zum Beispiel eine erleichterte Verarbeitbarkeit für weitere Prozeßschritte, leichtere Verfügbarkeit in größeren Abmessungen oder geringere Kosten aufweisen.

Die Erfindung eignet sich insbesondere für Halbleiterschichten, die einen Nitridverbindungshalbleiter enthalten. Nitridverbindungshalbleiter sind beispielsweise Nitridverbindungen von Elementen der dritten und/oder fünften Hauptgruppe des Periodensystems der chemischen Elemente wie GaN, AlGaN, InGaN, AlInGaN, InN oder AlN. Die Halbleiterschicht kann dabei auch eine Mehrzahl von Einzelschichten verschiedener Nitridverbindungshalbleiter umfassen. So kann die Halbleiterschicht zum Beispiel einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden daher an dieser Stelle nicht näher erläutert. Bevorzugt werden derartige Strukturen bei optoelektronischen Bauelementen wie Lichtemissionsdioden, beispielsweise in Form von Leuchtdioden (LEDs) oder Laserdioden, verwendet.

Für Nitridverbindungshalbleiter eignen sich beispielsweise Träger, die Galliumarsenid, Silizium, Germanium, Kupfer, Eisen, Nickel, Molybdän, Kobalt oder Wolfram oder eine Legierung, zum Beispiel auf der Basis von Eisen, Nickel und/oder Kobalt, enthalten.

Als Substrat für die epitaktische Herstellung von Nitridverbindungshalbleiter schichten sind beispielsweise Silizium-, Siliziumkarbid- oder Aluminiumoxid- bzw. Saphirsubstrate geeignet, wobei Saphirsubstrate vorteilhafterweise für die zur Abtrennung der Halbleiterschicht verwendete Laserstrahlung, insbesondere im ultravioletten Spektralbereich, durchlässig sind. Dies ermöglicht bei der Ablösung der Halbliterschicht eine Bestrahlung der Halbleiterschicht durch das Substrat hindurch.

Das erfindungsgemäße Verfahren kann mit Vorteil bei Dünnfilmchips (synonym: Dünnschichtchips) angewandt werden, die typischerweise eine Halbleiterschicht mit einer Dicke unterhalb von etwa 50 µm aufweist. Der Dünnfilmchip kann beispielsweise ein optoelektronischer Chip, insbesondere ein strahlungserzeugender Chip wie zum Beispiel ein Lichtemissionsdiodenchip sein.

Ein Dünnfilm-Lichtemissionsdioden-Chip zeichnet sich insbesondere durch folgende charakteristische Merkmale aus:
- an einer zu einem Trägerelement hin gewandten ersten Hauptfläche einer Strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- ein Dünnfilm-Lichtemissionsdioden-Chip ist in guter Näherung ein Lambert'scher Oberflächenstrahler;
- die Epitaxieschichtenfolge weist eine Dicke im Bereich von 20 µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnfilm-Lichtemissionsdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird. Es sei angemerkt, daß sich die vorliegende Erfindung zwar besonders auf Dünnfilm-Lichtemissionsdiodenchip bezieht, nicht jedoch auf diese beschränkt ist. Vielmehr eignet sich die vorliegende Erfindung neben Dünnfilm-Lichtemissionsdiodenchips auch für alle sonstigen Dünnfilmhalbleiterkörper.

Im Folgenden sind einige Aspekte der vorliegenden Erfindung in einer nummerierten Reihenfolge angegeben:
Aspekt 1. Verfahren zur Herstellung eines Halbleiterbauelements, bei dem eine Halbleiterschicht (2) von einem Substrat (1) durch Bestrahlen mit Laserimpulsen (6) getrennt wird,
   wobei die Impulsdauer der Laserimpulse (6) kleiner oder gleich 10 ns ist,
   dadurch gekennzeichnet, daß
   die Laserimpulse (6) ein räumliches Strahlprofil (7) aufweisen, dessen Flankensteilheit so gering gewählt ist, daß bei der Trennung von Halbleiterschicht (2) und Substrat (1) Risse in der Halbleiterschicht (2), die durch thermisch induzierte laterale Verspannungen entstehen, vermieden werden.
Aspekt 2. Verfahren nach Aspekt 1,
   dadurch gekennzeichnet, daß
   die Laserimpulse (6) ein räumlich gaußförmiges Strahlprofil aufweisen.
Aspekt 3. Verfahren nach Aspekt 1 oder 2,
   dadurch gekennzeichnet, daß
   die Laserimpulse (6) von einem Festkörperlaser mit einem Nd-dotierten laseraktiven Medium, vorzugsweise Nd:YAG, erzeugt werden.
Aspekt 4. Verfahren nach Aspekt 1 oder 2,
   dadurch gekennzeichnet, daß
   die Laserimpulse (6) von einem Excimerlaser erzeugt werden.
Aspekt 5. Verfahren nach einem der Aspekte 1 bis 3,
   dadurch gekennzeichnet, daß
   die Wellenlänge der Laserimpulse (6) zwischen 200 nm und 400 nm, vorzugsweise zwischen 300 nm und 400 nm liegt.
Aspekt 6. Verfahren nach einem der Aspekte 1 bis 5,
   dadurch gekennzeichnet, daß
   die Laserimpulse (6) derart auf die Halbleiterschicht (2) eingestrahlt werden, daß innerhalb des bestrahlten Bereichs die durch die Laserimpulse (6) erzeugte Energiedichte zwischen 100 mJ/cm² und 1000 mJ/cm², insbesondere zwischen 200 mJ/cm² und 400 mJ/cm², liegt.
Aspekt 7. Verfahren nach einem der Aspekte 1 bis 6,
   dadurch gekennzeichnet, daß
   mehrere Einzelbereiche (8) der Halbleiterschicht (2) nacheinander bestrahlt werden.
Aspekt 8. Verfahren nach einem der Aspekte 1 bis 7,
   dadurch gekennzeichnet, daß
   das Substrat (1) für die Laserimpulse (6) zumindest teilweise durchlässig ist, und die Halbleiterschicht (2) durch das Substrat (1) hindurch bestrahlt wird.
Aspekt 9. Verfahren nach einem der Aspekte 1 bis 8,
   dadurch gekennzeichnet, daß
   die Halbleiterschicht (2) vor der Trennung von dem Substrat (1) strukturiert wird.
Aspekt 10. Verfahren nach Aspekt 9,
   dadurch gekennzeichnet, daß
   zur Strukturierung der Halbleiterschicht (2) Vertiefungen in der Halbleiterschicht (2) ausgebildet werden, die vorzugsweise die Halbleiterschicht (2) bis zum Substrat (1) durchtrennen.
Aspekt 11. Verfahren nach Aspekt 10,
   dadurch gekennzeichnet, daß
   die strukturierte Halbleiterschicht (2) nachfolgend mit einer Passivierungsschicht (10), insbesondere mit einer elektrisch isolierenden Passivierungsschicht, versehen wird.
Aspekt 12. Verfahren nach einem der Aspekte 1 bis 11,
   dadurch gekennzeichnet, daß
   vor der Trennung von dem Substrat (1) die Halbleiterschicht (2) mit der von dem Substrat (1) abgewandten Seite auf einen Träger (4) aufgebracht, vorzugsweise gelötet wird.
Aspekt 13. Verfahren nach Aspekt 12,
   dadurch gekennzeichnet, daß
   der thermische Ausdehnungskoeffizient des Trägers auf das Strahlprofil und/oder die Impulsdauer der Laserimpulse und auf den thermischen Ausdehnungskoeffizienten der Halbleiterschicht und den thermischen Ausdehnungskoeffizienten des Substrats abgestimmt gewählt wird, um Verspannungen zwischen Substrat, Halbleiterschicht und Träger während der Herstellung zu reduzieren.
Aspekt 14. Verfahren nach Aspekt 12 oder 13,
   dadurch gekennzeichnet, daß
   der thermische Ausdehnungskoeffizient des Trägers näher an dem thermischen Ausdehnungskoeffizienten der Halbleiterschicht als an dem thermischen Ausdehnungskoeffizienten des Substrats gewählt wird.
Aspekt 15. Verfahren nach einem der Aspekt 12 bis 14,
   dadurch gekennzeichnet, daß
   der Träger (4) Galliumarsenid, Silizium, Germanium, Kupfer, Eisen, Nickel, Kobalt, Molybdän, Wolfram oder eine geeignete Mischung oder Legierung dieser Materialien enthält.
Aspekt 16. Verfahren nach einem der Aspekte 12 bis 15,
   dadurch gekennzeichnet, daß
   die Halbleiterschicht (2) mittels eines Lots, das Gold und/oder Zinn oder Palladium und/oder Indium enthält, auf den Träger (4) gelötet wird.
Aspekt 17. Verfahren nach einem der Aspekte 12 bis 16,
   dadurch gekennzeichnet, daß
   vor dem Verbinden der Halbleiterschicht (2) mit dem Träger (4) auf die von dem Substrat (1) abgewandte Seite der Halbleiterschicht (2) eine Metallisierung aufgebracht wird.
Aspekt 18. Verfahren nach Aspekt 17,
   dadurch gekennzeichnet, daß
   die Metallisierung Gold und/oder Platin enthält.
Aspekt 19. Verfahren nach einem der Aspekte 1 bis 18,
   dadurch gekennzeichnet, daß
   die Halbleiterschicht (2) eine Mehrzahl von Einzelschichten umfaßt.
Aspekt 20. Verfahren nach einem der Aspekte 1 bis 19,
   dadurch gekennzeichnet, daß
   die Halbleiterschicht (2) bzw. mindestens eine der Einzelschichten einen Nitridverbindungshalbleiter enthält.
Aspekt 21. Verfahren nach Aspekt 20,
   dadurch gekennzeichnet, daß
   der Nitridverbindungshalbleiter eine Nitridverbindung von Elementen der dritten und/oder fünften Hauptgruppe ist.
Aspekt 22. Verfahren nach einem der Aspekte 20 oder 21,
   dadurch gekennzeichnet, daß
   die Halbleiterschicht (2) bzw. mindestens eine der Einzelschichten InₓAl_{y}Ga_{1-x-y}N mit 0 ≤ x ≤ 1, 0 ≤ y ≤ 1 und x+y ≤ 1, insbesondere GaN, AlGaN, InGaN, AlInGaN, AlN oder InN enthält.
Aspekt 23. Verfahren nach einem der Aspekte 1 bis 22,
   dadurch gekennzeichnet, daß
   das Substrat (1) Silizium, Siliziumkarbid oder Aluminiumoxid, insbesondere Saphir, enthält.
Aspekt 24. Verfahren nach einem der Aspekte 1 bis 23,
   dadurch gekennzeichnet, daß
   die Halbleiterschicht (2) mittels eines Epitaxieverfahrens auf das Substrat (1) aufgebracht wird.
Aspekt 25. Verfahren nach einem der Aspekte 1 bis 24,
   dadurch gekennzeichnet, daß
   die Halbleiterschicht (2) eine Dicke aufweist, die kleiner oder gleich 50 µm, vorzugsweise kleiner oder gleich 20 µm, besonders bevorzugt kleiner oder gleich 1µm ist.
Aspekt 26. Verfahren nach einem der Aspekte 1 bis 25,
   dadurch gekennzeichnet, daß
   das Halbleiterbauelement eine Lichtemissionsdiode, insbesondere eine Leuchtdiode oder eine Laserdiode ist.

Weitere Merkmale, Vorzüge und Zweckmäßigkeiten der Erfindung ergeben sich aus der Beschreibung der nachfolgenden zwei Ausführungsbeispiele der Erfindung in Verbindung mit den Figuren 1 bis 3.

Es zeigen:
Figur 1a bis 1e eine schematische Darstellung eines ersten Ausführungsbeispiels eines erfindungsgemäßen Verfahrens anhand von fünf Zwischenschritten,
Figur 2 eine schematische Darstellung eines Strahlprofils der Laserimpulse bei dem in Figur 1 gezeigten Verfahren, und
Figur 3a bis 3e eine schematische Darstellung eines zweiten Ausführungsbeispiels eines erfindungsgemäßen Verfahrens anhand von fünf Zwischenschritten.

Gleiche oder gleich wirkende Elemente sind in den Figuren mit denselben Bezugszeichen versehen.

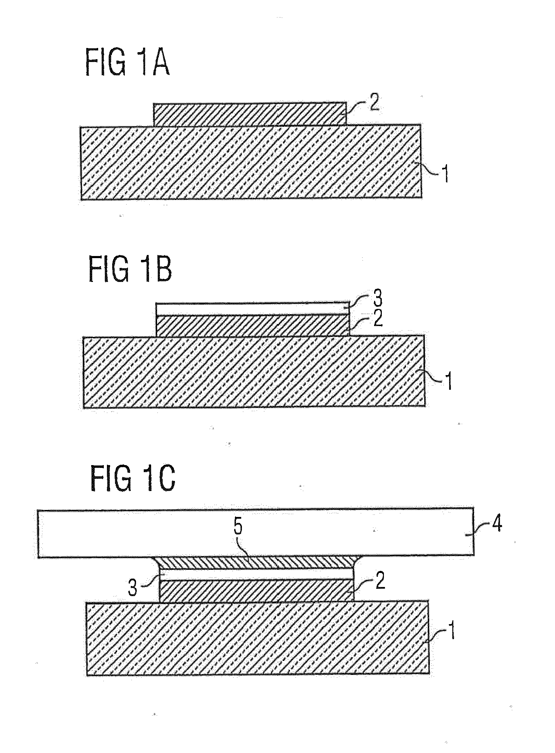

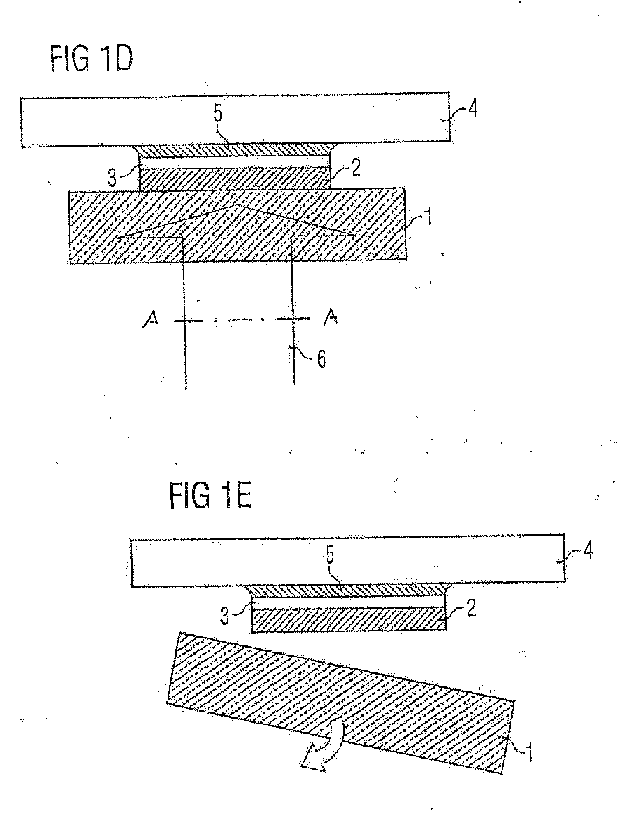

Im ersten Schritt des in Figur 1 dargestellten Verfahrens, Figur 1a, wird auf ein Substrat 1 eine Halbleiterschicht 2 aufgebracht. Dies kann eine Nitridverbindungshalbleiterschicht, beispielsweise eine InGaN-Schicht, sein, die epitaktisch auf ein Saphirsubstrat aufgewachsen wird. Weitergehend kann die Halbleiterschicht 2 auch eine Mehrzahl von Einzelschichten, die zum Beispiel GaN, AlN, AlGaN, InGaN, InN oder InAlGaN enthalten können und nacheinander auf das Substrat 1 aufgewachsen werden, umfassen.

Im nächsten Schritt, Figur 1b, wird die Halbleiterschicht 2 auf der von dem Substrat abgewandten Seite mit einer Kontaktmetallisierung 3 versehen. Die Kontaktmetallisierung 3 kann beispielsweise in Form einer dünnen gold- und/oder platinhaltigen Schicht aufgedampft oder aufgesputtert werden.

Nachfolgend wird auf die Kontaktmetallisierung 3 ein Träger 4 aufgelötet, Figur 1c. Als Lot 5 wird vorzugsweise ein goldhaltiges Lot verwendet, beispielsweise ein Gold-Zinn-Lot mit einem Goldanteil zwischen 65 Gew% und 85 Gew%, bevorzugt 75 Gew%. Eine solche Lötverbindung zeichnet sich durch eine hohe thermische Leitfähigkeit und eine hohe Stabilität unter Temperaturwechselbelastungen aus.

Als Träger 4 kann beispielsweise ein Galliumarsenid-Wafer verwendet werden, der einen ähnlichen thermischen Ausdehnungskoeffizienten wie Saphir aufweist.

Bevorzugt ist ein Träger 4 in Form eines Bondwafers aus Molybdän vorgesehen. Die thermischen Ausdehnungskoeffizienten des Bondwafers a(Mo) = 5,21 * 10⁻⁶ K⁻¹ und des Saphirsubstrats a(Al₂O₃) = 7,5 * 10⁻⁶ K⁻¹ liegen relativ nahe beieinander, so daß thermisch induzierte Verspannungen in der Halbleiterschicht 2 vorteilhafterweise gering gehalten werden. Darüber hinaus ist Molybdän ausreichend zäh, so daß beim Bonden und beim Abkühlen von der Bondtemperatur auf Zimmertemperatur keine Risse im Molybdän-Bondwafer entstehen.

Statt eines Galliumarsenid-Wafers kann bei der Erfindung auch ein Germanium-Wafer verwendet werden. Der thermische Ausdehnungskoeffizient von Germanium ist ähnlich dem von Galliumarsenid, so daß sich diesbezüglich kaum Unterschiede ergeben. Ein Germanium-Wafer weist jedoch gegenüber einem Galliumarsenid-Wafer den Vorteil auf, daß er leichter gesägt werden kann, wobei insbesondere keine arsenhaltigen, giftigen Sägeabfälle anfallen. Weiterhin sind Germanium-Wafer mechanisch stabiler. So wird beispielsweise mit einem 200µm dicken Germanium-Wafer bereits eine ausreichende Stabilität erreicht, wohingegen die Dicke eines entsprechenden Galliumarsenid-Wafers größer als 600µm ist.

Vorteilhafterweise ist es hierbei auch nicht erforderlich, den Germanium-Wafer in einem weiteren Verfahrensschritt durch Schleifen abzudünnen. Schließlich sind Germanium-Wafer in der Regel deutlich kostengünstiger als Galliumarsenid-Wafer.

Vorzugsweise wird in Verbindung mit einem Germanium-Wafer ein goldhaltiges Lot oder Gold selbst als Lot verwendet. Hiermit wird eine besonders feste Verbindung mit der Halbleiterschicht erreicht. Besonders bevorzugt ist ein goldbedampfter Germanium-Wafer, der optional mit einer Gold-Antimon-Oberflächenschicht versehen sein kann, vorgesehen.

Im darauffolgenden Schritt, Figur 1d, wird die HalbleiterSchicht 2 durch das Substrat 1 hindurch mit Laserimpulsen 6 bestrahlt. Die Strahlungsenergie wird vorwiegend in der Halbleiterschicht 2 absorbiert und bewirkt an der Grenzfläche zwischen der Halbleiterschicht 2 und dem Substrat 1 eine Materialzersetzung, so daß nachfolgend das Substrat 1 abgehoben werden kann, Figur 1e. Die Laserimpulse 6 werden von einem gütegeschalteten Nd:YAG-Laser erzeugt und mittels eines nichtlinearen optischen Elements frequenzverdreifacht, so daß Laserimpulse 6 mit einer Wellenlänge von etwa 355 nm auf die Halbleiterschicht 2 eingestrahlt werden. Die Impulsdauer der Laserimpulse beträgt 7 ns oder bei einer Variante 10 ns. Weiterhin ist die Energie der Laserimpulse so bemessen, daß im räumlichen Zentrum des Laserimpulses die Energiedichte zwischen 100 mJ/cm² und 1000 mJ/cm², bevorzugt zwischen 200 mJ/cm² und 400 mJ/cm² liegt.

Wesentlich ist bei der Erfindung zum einen, daß die eingestrahlte und grenzflächennah in der Halbleiterschicht absorbierte Strahlungsenergie so gewählt ist, daß lokal an der Grenzfläche zwischen dem Substrat 1 und der Halbleiterschicht 2 eine hohe, zur Materialzersetzung ausreichende Temperatur entsteht, die über die Schichtdicke der Halbleiterschicht so weit abfällt, daß die Verbindung 5 zwischen dem Träger 4 und dem der Halbleiterschicht nicht beeinträchtigt wird, beispielsweise aufschmilzt. Dies wird durch die kurze Impulsdauer der Laserimpulse von kleiner oder gleich 10 ns erreicht.

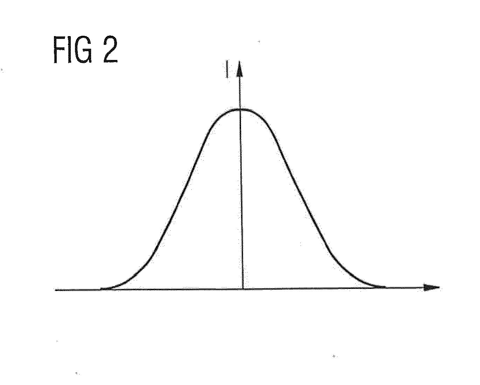

Zum anderen ist bei gegebener Impulsdauer und -energie das Strahlprofil so anzupassen, daß keine Risse in der abzulösenden Schicht entstehen. Das transversale Strahlprofil der Laserimpulse ist in Figur 2 dargestellt. Aufgetragen ist die Strahlintensität längs der Linie A-A. Das Strahlprofil ist näherungsweise gaußförmig. In Verbindung mit der genannten kurzen Impulsdauer hat sich ein solches Strahlprofil als vorteilhaft erwiesen, da die lateralen Flanken nicht zu abrupt abfallen und somit ein fließender Übergang zwischen dem bestrahlten und dem benachbarten, nichtbestrahlten Bereich entsteht. Dies verringert den lateralen Temperaturgradienten und in der Folge mechanische Verspannungen und Rißbildungen in der Halbleiterschicht.

Allgemein ist bei der Erfindung die Flankensteilheit des Strahlprofils so gering gewählt, daß bei der Trennung Risse aufgrund von thermisch induzierten mechanischen Spannungen vermieden werden. Eine geeignete Flankensteilheit kann beispielsweise experimentell dadurch ermittelt werden, daß bei konstanter Energiedichte im Zentrum des Laserimpulses die Flankensteilheit, beispielsweise mittels des Durchmessers des Laserimpulses, schrittweise variiert wird und jeweils anhand einer damit bestrahlten Probe beurteilt wird, ob wie gewünscht Risse beim Ablöseprozeß vermieden werden. Gegebenenfalls sind mehrere Versuche durchzuführen und statistisch auszuwerten.

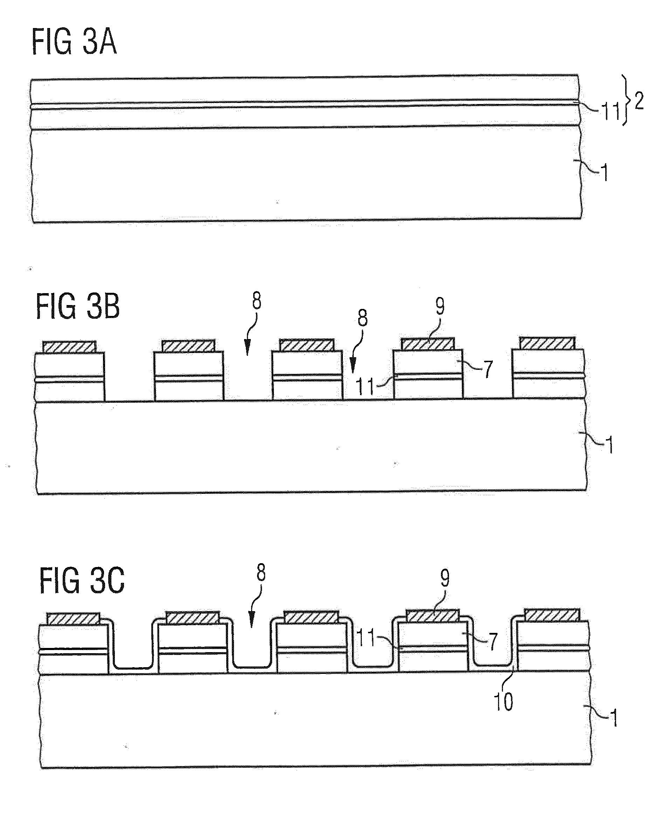

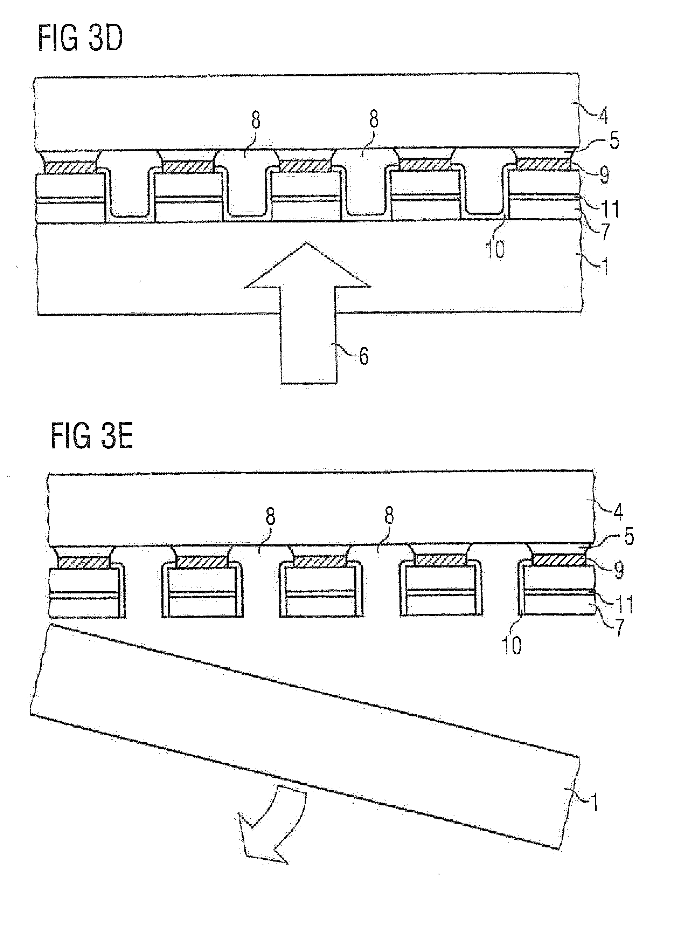

In Figur 3 ist ein weiteres Ausführungsbeispiel der Erfindung dargestellt. Wie bei dem in Figur 1 gezeigten Ausführungsbeispiel wird zunächst auf ein Substrat 1 eine Halbleiterschicht 2 aufgebracht. Die Halbleiterschicht 2 kann wie bei dem ersten Ausführungsbeispiel einen oder mehrere Nitridverbindungshalbleiter enthalten, eine Mehrzahl von Einzelschichten umfassen und auf einem Saphirsubstrat aufgewachsen sein. Vorzugsweise dient diese Halbleiterschicht zur Strahlungserzeugung und weist eine entsprechende aktive Strahlungserzeugende Zone 11 auf.

Im nächsten Schritt, Figur 3b, wird die Halbleiterschicht zunächst oberseitig mit Kontaktmetallisierung 9 versehen. Zur Herstellung einzelner Halbleiterkörper 7 wird die Halbleiterschicht nachfolgend strukturiert, wobei eine Mehrzahl von Vertiefungen 8 bis zum Substrat in der Halbleiterschicht gebildet werden. Diese Vertiefungen 8 umschließen lateral die zu bildenden Halbleiterkörper 7. Beispielweise können derartige Vertiefungen 8 in die Halbleiterschicht geätzt werden. Diese Chipstrukturierung hat den Vorteil, daß durch die Vertiefungen 8 in lateraler Richtung eine gewisse Flexibilität entsteht und so mechanische Spannungen in der Halbleiterschicht abgebaut werden können.

Nachfolgend wird auf die Halbleiterschicht 2 bzw. die Halbleiterkörper 7 eine vorzugsweise elektrisch isolierende Passivierungsschicht 10, zum Beispiel eine Siliziumnitridschicht, zum Schutz der Halbleiteroberflächen aufgebracht. Diese Passivierungsschicht 10 bedeckt insbesondere auch die durch die Vertiefungen freigelegten Seitenflächen der Halbleiterkörper. Damit wird verhindert, daß bei nachfolgenden Schritten elektrisch leitendes Material auf die freigelegten Seitenflächen gelangt und beispielsweise die aktive Schicht kurzschließt. Ansonsten könnte beim nachfolgenden Auflöten des Trägers Lot die Seitenflächen benetzen oder es könnten Rückstände beim späteren Ablösen des Substrats, etwa metallisches Gallium bei GaN-basierenden Schichten, auf den Seitenflächen anhaften und einen solchen Kurzschluß bewirken.

Die Passivierungsschicht 10 ist dabei vorzugsweise so dimensioniert, daß eine Schichtartige Bedeckung der freigelegten Seitenflächen und Substratbereiche erfolgt, wobei eine vollständige Füllung der Vertiefungen vermieden wird. Eine Bedeckung der Kontaktmetallisierung (nicht dargestellt) mit der Passivierungsschicht wird wieder entfernt.

Danach werden die Halbleiterschicht 2 bzw. die Halbleiterkörper 7 und die gegebenenfalls dazwischenliegenden Bereiche 8 wie bei dem in Figur 1d gezeigten Ausführungsbeispiel mit Laserimpulsen einer Impulsdauer kleiner oder gleich 10 ns und einer ausreichend geringen Flankensteilheit im Strahlprofil bestahlt.

Im letzten Schritt, Figur 3e wird das Substrat wie bereits im Zusammenhang mit Figur 1e beschrieben abgehoben und entfernt.

Die Erläuterung der Erfindung anhand der beschriebenen Ausführungsbeispiele stellt selbstverständlich keine Einschränkung hierauf dar. Vielmehr können einzelne Aspekte der Ausführungsbeispiele weitgehend frei im Rahmen der Erfindung miteinander kombiniert werden. Weiterhin umfaßt die Erfindung jedes neue Merkmal sowie jede Kombination von Merkmalen, was insbesondere jede Kombination von Merkmalen in den Patentansprüchen beinhaltet, auch wenn diese Kombination nicht explizit in den Patentansprüchen angegeben ist.

## Patentansprüche

1. Verfahren zur Herstellung eines Halbleiterbauelements, bei dem eine Halbleiterschicht (2) von einem Substrat (1) durch Bestrahlen mit Laserimpulsen (6) getrennt wird, wobei die Impulsdauer der Laserimpulse (6) kleiner oder gleich 10 ns ist,
**dadurch gekennzeichnet, daß**
- vor der Trennung von dem Substrat (1) die Halbleiterschicht (2) mit der von dem Substrat (1) abgewandten Seite auf einen Träger (4) aufgebracht wird,
- die Laserimpulse (6) ein räumliches Strahlprofil (7) aufweisen, dessen Flankensteilheit so gering gewählt ist, daß Risse in der Halbleiterschicht (2), die durch thermisch induzierte laterale Verspannungen entstehen, vermieden werden, wobei das räumliche Strahlprofil gaußartige, hypergaußartige oder lorentzartige Flanken aufweist,
- das Substrat Saphir aufweist, und
- der Träger (4) ein Molybdän-Wafer ist.

2. Verfahren nach Anspruch 1,
**dadurch gekennzeichnet, daß**
die Laserimpulse (6) von einem Festkörperlaser mit einem Nd-dotierten Laseraktiven Medium, vorzugsweise Nd:YAG, erzeugt werden.

3. Verfahren nach einem der Ansprüche 1 bis 2,
**dadurch gekennzeichnet, daß**
die Wellenlängen der Laserimpulse (6) zwischen 200 nm und 400nm, vorzugsweise zwischen 300 nm und 400 nm liegt.

4. Verfahren nach einem der obigen Ansprüche,
**dadurch gekennzeichnet, daß**
die Laserimpulse (6) derart auf die Halbleiterschicht (2) eingestrahlt werden, daß innerhalb des bestrahlten Bereichs die durch die Laserimpulse (6) erzeugte Energiedichte zwischen 100 mJ/cm² und 1000 mJ/cm², insbesondere zwischen 200 mJ/cm² und 400 mJ/cm², liegt.

5. Verfahren nach einem der obigen Ansprüche,
**dadurch gekennzeichnet, daß**
mehrere Einzelbereiche (8) der Halbleiterschicht (2) nacheinander bestrahlt werden.

6. Verfahren nach einem der obigen Ansprüche,
**dadurch gekennzeichnet, daß**
das Substrat (1) für die Laserimpulse (6) zumindest teilweise durchlässig ist, und die Halbleiterschicht (2) durch das Substrat (1) hindurch bestrahlt wird.

7. Verfahren nach einem der obigen Ansprüche,
**dadurch gekennzeichnet, daß**
die Halbleiterschicht (2) vor der Trennung von dem Substrat (1) strukturiert wird.

8. Verfahren nach dem vorherigen Anspruch,
**dadurch gekennzeichnet, daß**
zur Strukturierung der Halbleiterschicht (2) Vertiefungen in der Halbleiterschicht (2) ausgebildet werden, die vorzugsweise die Halbleiterschicht (2) bis zum Substrat (1) durchtrennen.

9. Verfahren nach dem vorherigen Anspruch,
**dadurch gekennzeichnet, daß**
die strukturierte Halbleiterschicht (2) nachfolgend mit einer Passivierungsschicht (10), insbesondere mit einer elektrisch isolierenden Passivierungsschicht, versehen wird.

10. Verfahren nach einem der obigen Ansprüche,
**dadurch gekennzeichnet, daß**
die Halbleiterschicht (2) mit der von dem Substrat (1) abgewandten Seite auf den Träger (4) gelötet wird.

11. Verfahren nach einem der obigen Ansprüche,
**dadurch gekennzeichnet, daß**
die Halbleiterschicht (2) mittels eines Lots, das Gold und/oder Zinn oder Palladium und/oder Indium enthält, auf den Träger (4) gelötet wird.

12. Verfahren nach einem der obigen Ansprüche,
**dadurch gekennzeichnet, daß**
vor dem Verbinden der Halbleiterschicht (2) mit dem Träger (4) auf die von dem Substrat (1) abgewandte Seite der Halbleiterschicht (2) eine Metallisierung aufgebracht wird.

13. Verfahren nach dem vorherigen Anspruch,
**dadurch gekennzeichnet, daß**
die Metallisierung Gold und/oder Platin enthält.

14. Verfahren nach einem der obigen Ansprüche,
**dadurch gekennzeichnet, daß**
die Halbleiterschicht (2) eine Mehrzahl von Einzelschichten umfaßt, wobei die die Halbleiterschicht (2) bzw. mindestens eine der Einzelschichten einen Nitridverbindungshalbleiter enthält.

15. Verfahren nach einem der obigen Ansprüche,
**dadurch gekennzeichnet, daß**
die Halbleiterschicht (2) mittels eines Epitaxieverfahrens auf das Substrat (1) aufgebracht wird.
